(19) Europäisches Patentamt / European Patent Office / Office européen des brevets

(11) **EP 4 745 606 A1**

(12) **EUROPEAN PATENT APPLICATION**

(43) Date of publication:
20.05.2026 Bulletin 2026/21

(21) Application number: 25210929.3

(22) Date of filing: 24.10.2025

(51) International Patent Classification (IPC):
$G01R\ 31/52^{(2020.01)}$ $\qquad G01R\ 31/396^{(2019.01)}$
$G01R\ 31/56^{(2020.01)}$

(52) Cooperative Patent Classification (CPC):
G01R 31/52; G01R 31/396; G01R 31/56;
H01M 10/4207; H01M 10/425; H01M 10/48;
H01M 10/482; H01M 2010/4271; H01M 2220/30

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 14.11.2024 CN 202411633923
14.11.2024 CN 202411630884
26.08.2025 CN 202511206164
26.08.2025 CN 202511203183

(71) Applicant: Nanjing Chervon Industry Co., Ltd.
Nanjing, Jiangsu 211106 (CN)

(72) Inventors:
• YUAN, Yongjie
  Nanjing (CN)
• JI, Yongchao
  Nanjing (CN)
• LIU, Weixuan
  Nanjing (CN)
• WEI, Junyu
  Nanjing (CN)

(74) Representative: Sun, Yiming
HUASUN Patent- und Rechtsanwälte
Friedrichstraße 33
80801 München (DE)

(54) **BATTERY PACK FOR POWERING A POWER TOOL AND INTERNAL SHORT CIRCUIT IDENTIFICATION METHOD THEREFOR**

(57) Provided are a battery pack for powering a power tool and an internal short circuit identification method therefor. The battery pack includes at least one cell module, and each cell module includes at least P cells connected in parallel. The internal short circuit identification method includes: acquiring a first voltage of each cell module and a second voltage of each cell module separately, where the first voltage and the second voltage are voltages of the cell module at different moments, respectively; determining an internal short circuit factor of the cell module based on the difference between the second voltage of the cell module and the first voltage of the cell module; and calculating and using the sum of all internal short circuit factors of each cell module as a total internal short circuit factor after the number of internal short circuit factors of each cell module reaches a preset number, and determining that an internal short circuit fault occurs in the battery pack when the total internal short circuit factor is greater than or equal to a first threshold k1.

EP 4 745 606 A1

## Description

## TECHNICAL FIELD

The present application relates to the technical field of tool devices and, in particular, to a battery pack for powering a power tool and an internal short circuit identification method therefor.

## BACKGROUND

A battery pack in the related art is used for powering a power tool. When an internal fault occurs in a lithium battery, for example, an internal short circuit occurs in the lithium battery, thermal runaway of the battery is easily caused due to temperature rise, thereby causing a serious loss to a user. Therefore, internal short circuit identification and a thermal runaway warning are performed on the battery pack in advance, which has a great effect on improving the safety of the battery.

This part provides background information related to the present application, and the background information is not necessarily the existing art.

## SUMMARY

An object of the present application is to solve or at least alleviate part or all of the preceding problems. To this end, an object of the present application is to provide a battery pack adaptable to a power tool and an internal short circuit identification method and a thermal runaway warning method therefor.

To achieve the preceding object, the present application adopts the technical solutions below. An internal short circuit identification method for a battery pack is provided. The battery pack includes at least one cell module, and each cell module includes at least P cells connected in parallel, where P ≥ 1. The internal short circuit identification method includes the steps described below.

A first voltage of each cell module and a second voltage of each cell module are acquired, where the first voltage and the second voltage are voltages of the cell module at different moments, respectively; an internal short circuit factor of the cell module is determined based on the difference between the second voltage of the cell module and the first voltage of the cell module; the sum of all internal short circuit factors of each cell module is calculated and used as a total internal short circuit factor when the number of internal short circuit factors of each cell module reaches a preset number; and it is determined that an internal short circuit fault occurs in the battery pack when the total internal short circuit factor is greater than or equal to a first threshold k1.

In some examples, the first voltage of each cell module and the second voltage of each cell module are acquired separately after balance of the battery pack ends and the battery pack rests for a preset time.

In some examples, the maximum value of total internal short circuit factors of each cell module is determined as the maximum total internal short circuit factor $k_{max}$, and a fault level of the internal short circuit fault of the battery pack is determined according to the maximum total internal short circuit factor $k_{max}$.

In some examples, when k1 < $k_{max}$ ≤ k2, it is determined that a first-level internal short circuit fault occurs in the battery pack, where k2 is a second threshold.

In some examples, when k2 < $k_{max}$ ≤ k3, it is determined that a second-level internal short circuit fault occurs in the battery pack, where k3 is a third threshold.

In some examples, after it is determined that the second-level internal short circuit fault occurs in the battery pack, a communication module of the battery pack is controlled to send first fault information.

In some examples, when $k_{max}$ > k3, it is determined that a three-level short circuit fault occurs in the battery pack.

In some examples, after it is determined that the three-level short circuit fault occurs in the battery pack, the battery pack is prohibited from being charged and discharged and a communication module of the battery pack is controlled to send second fault information.

In some examples, the internal short circuit factor of the cell module is determined according to a second formula based on the difference between the second voltage of the cell module and the first voltage of the cell module, where the second formula is as follows:

$$ k_{isc} = \frac{dV_{max} - dV_x}{dV_{threshold}}; $$

where $k_{isc}$ denotes the internal short circuit factor, $dV_{max}$ denotes a reference voltage, $dV_x$ denotes the difference between the second voltage and the first voltage, and $dV_{threshold}$ denotes a voltage threshold.

In some examples, the voltage threshold is determined according to a variation in a state of charge (SOC) of the battery pack and a preset curve.

In some examples, the reference voltage is the minimum value of the difference between the second voltage of each cell module and the first voltage of each cell module acquired by the battery pack for the first time.

An example provides a battery pack for powering a power tool. The battery pack includes: a cell assembly including at least one cell module, where each cell module includes at least P cells connected in parallel, where P ≥ 1; and a power management unit, where the power management unit is electrically connected to the cell assembly to control the cell assembly to be charged or discharged. The power management unit is configured to: calculate an internal short circuit factor of the cell module at least P times based on variations in voltages of the cell module within a preset duration separately;

calculate and use the sum of the at least P internal short circuit factors of each cell module as a total internal short circuit factor; and determine that an internal short circuit fault occurs in the battery pack when a total internal short circuit factor is greater than or equal to a first threshold.

An example provides an internal short circuit identification method for a battery pack. The battery pack includes at least one cell module, and each cell module includes at least two cells connected in parallel. The internal short circuit identification method includes: acquiring a first voltage and a first state of charge (SOC) of each cell module at a first moment and a second voltage and a second state of charge of each cell module at a second moment separately; determining an internal short circuit factor of the cell module based on the difference between the second voltage of the cell module and the first voltage of the cell module, the second state of charge of the cell module, and the first state of charge of the cell module; and determining that an internal short circuit fault occurs in the battery pack when the internal short circuit factor is greater than or equal to a fourth threshold.

In some examples, determining the internal short circuit factor of the cell module based on the difference between the second voltage of the cell module and the first voltage of the cell module, the second state of charge of the cell module, and the first state of charge of the cell module includes: determining a voltage threshold based on the second state of charge of the cell module, the first state of charge of the cell module, and a preset curve; and determining the internal short circuit factor of the cell module based on the difference between the second voltage of the cell module and the first voltage of the cell module and the voltage threshold and based on a second formula, where the second formula is as follows:

$$\mathrm{k_{isc}} = \frac{dV_{max} - dV_x}{dV_{threshold}};$$

where $k_{isc}$ denotes the internal short circuit factor, $dV_{max}$ denotes a reference voltage, $dV_x$ denotes the difference between the second voltage and the first voltage, and $dV_{threshold}$ denotes the voltage threshold.

In some examples, the reference voltage is the minimum value of the difference between the second voltage of each cell module and the first voltage of each cell module acquired by the battery pack for the first time.

In some examples, when the internal short circuit factor is greater than or equal to a fifth threshold, it is determined that a second-level internal short circuit fault occurs in the battery pack, where the fifth threshold is greater than the fourth threshold.

In some examples, when the second-level internal short circuit fault occurs in the battery pack, a communication module of the battery pack is controlled to send third fault information.

In some examples, when the internal short circuit factor is greater than or equal to a sixth threshold, it is determined that a third-level internal short circuit fault occurs in the battery pack, where the sixth threshold is greater than the fifth threshold.

In some examples, when the three-level internal short circuit fault occurs in the battery pack, the battery pack is prohibited from being charged and discharged and a communication module of the battery pack is controlled to send fourth fault information.

In some examples, the time interval between the first moment and the second moment is 6 h.

An example provides a battery pack for powering a power tool. The battery pack includes: a cell assembly including at least one cell module, where each cell module includes at least one cell connected in parallel; and a power management unit, where the power management unit is electrically connected to the cell assembly to control the cell assembly to be charged or discharged. The power management unit is configured to: calculate an internal short circuit factor of the cell module based on a variation in a state of charge of the cell module and a variation in a voltage of the cell module within a preset period; and determine that an internal short circuit fault occurs in the battery pack when the internal short circuit factor is greater than or equal to a fourth threshold.

An example provides an abnormality warning method for a battery pack. The method includes: acquiring a temperature of the battery pack in real time; estimating a thermal runaway temperature of the battery pack and a temperature rise rate of the battery pack based on an estimation unit; and estimating, based on a temperature of the battery pack at a current moment, the thermal runaway temperature of the battery pack, and the temperature rise rate of the battery pack, the duration for which an abnormality of the battery pack occurs.

In some examples, estimating the thermal runaway temperature of the battery pack includes: acquiring at least one of a state of charge of the battery pack, a state of health of the battery pack, and an internal temperature of a cell; and estimating the thermal runaway temperature based on the at least one of the state of charge of the battery pack, the state of health of the battery pack, and the internal temperature of the cell.

In some examples, the battery pack includes at least one cell assembly, and acquiring the internal temperature (SOT) of the cell of the battery pack includes: acquiring a voltage of the battery pack and an internal resistance of the battery pack; and determining the internal temperature of the cell assembly based on the voltage, the internal resistance, and the temperature of the battery pack.

In some examples, estimating, based on the temperature of the battery pack at the current moment, the thermal runaway temperature of the battery pack, and the temperature rise rate of the battery pack, the duration for which the abnormality of the battery pack occurs includes estimating, according to a first formula based on the temperature of the battery pack at the current moment, the thermal runaway temperature of the battery pack, and the temperature rise rate of the battery pack, the duration for which the abnormality of the battery pack occurs. The first formula includes the following: t_remaining = (T fire - T_now)/(Rat of T_cell), where t_remaining denotes the duration for which the abnormality of the battery pack occurs, T_fire denotes the thermal runaway temperature, T_now denotes the temperature at the current moment, and Rat of T_cell denotes the temperature rise rate.

In some examples, a warning signal is outputted to notify the user when the duration for which the abnormality of the battery pack occurs is less than or equal to a duration threshold.

In some examples, acquiring the temperature of the battery pack in real time includes acquiring the temperature of the battery pack in real time based on a detection unit.

In some examples, the battery pack includes at least one cell assembly, the detection unit includes at least one temperature sensor disposed on a surface of the cell assembly, and acquiring the temperature of the battery pack in real time based on the detection unit includes the following: the detection unit acquires sensing data of the temperature sensor in real time and determines the temperature of the surface of the cell assembly according to the data of the sensor.

In some examples, the rated voltage U of the battery pack ranges from 24 V to 60 V.

An example provides a charging system. The charging system includes: a battery pack and a charger for charging the battery pack, where the battery pack includes a cell assembly, and the cell assembly is configured to be connected to the charger to store electric energy or be connected to a power tool to release electric energy; a temperature acquisition unit, where the temperature acquisition unit is configured to acquire a temperature of the battery pack in real time; an estimation unit, where the estimation unit is configured to estimate a thermal runaway temperature of the battery pack and a temperature rise rate of the battery pack; and an abnormality warning unit, where the abnormality warning unit is configured to estimate, based on a current temperature, thermal runaway temperature, and temperature rise rate of the battery pack, the duration for which an abnormality of the battery pack occurs.

In some examples, the estimation unit is specifically configured to: acquire at least one of a state of charge of the battery pack, a state of health of the battery pack, and an internal temperature of a cell; and estimate the thermal runaway temperature based on the at least one of the state of charge of the battery pack, the state of health of the battery pack, and the internal temperature of the cell.

In some examples, the estimation unit is specifically configured to acquire a voltage of the battery pack and an internal resistance of the battery pack and determine the internal temperature of the cell based on the voltage, the internal resistance, and the temperature of the battery pack.

In some examples, the estimation unit is specifically configured to: acquire the voltage of the battery pack and the internal resistance of the battery pack; and determine an internal temperature of the cell assembly based on the voltage, the internal resistance, and the temperature of the battery pack.

In some examples, the abnormality warning unit is specifically configured to estimate, based on a temperature of the battery pack at a current moment, the thermal runaway temperature of the battery pack, and the temperature rise rate of the battery pack according to the first formula, the duration for which the abnormality of the battery pack occurs. The first formula includes the following: t_remaining = (T_fire - T_now)/(Rat of T_cell), where t_remaining denotes the duration for which the abnormality of the battery pack occurs, T_fire denotes the thermal runaway temperature, T_now denotes the temperature at the current moment, and Rat of T_cell denotes the temperature rise rate.

An example provides an abnormality warning method for a battery pack. The method includes: acquiring a temperature of the battery pack in real time; estimating a thermal runaway temperature of the battery pack and a temperature rise rate of the battery pack based on an estimation unit; and predicting a thermal runaway event of the battery pack before a preset time based on the relationship among a temperature of the battery pack at a current moment, the thermal runaway temperature of the battery pack, and the temperature rise rate of the battery pack.

**BRIEF DESCRIPTION OF DRAWINGS**

FIG. 1 is a structural view showing power tools and a battery pack according to an example of the present application.

FIG. 2 shows a temperature variation curve during a thermal runaway test of a battery pack according to an example of the present application.

FIG. 3 is a flowchart of an abnormality warning method for a battery pack according to an example of the present application.

FIG. 4 is a block diagram of a charging system according to an example of the present application.

FIG. 5 is another flowchart of an abnormality warning method for a battery pack according to an example of the present application.

FIG. 6 is a flowchart of an internal short circuit identification method for a battery pack according to an example of the present application.

FIG. 7 shows a preset curve according to an example of the present application.

FIG. 8 is another flowchart of an internal short circuit identification method for a battery pack according to an example of the present application.

FIG. 9 is a schematic diagram of the arrangement of a cell assembly according to an example of the present application.

## DETAILED DESCRIPTION

Before any examples of this application are explained in detail, it is to be understood that this application is not limited to its application to the structural details and the arrangement of components set forth in the following description or illustrated in the above drawings.

In this application, the terms "comprising", "including", "having" or any other variation thereof are intended to cover an inclusive inclusion such that a process, method, article or device comprising a series of elements includes not only those series of elements, but also other elements not expressly listed, or elements inherent in the process, method, article, or device. Without further limitations, an element defined by the phrase "comprising a ..." does not preclude the presence of additional identical elements in the process, method, article, or device comprising that element.

In this application, the term "and/or" is a kind of association relationship describing the relationship between associated objects, which means that there can be three kinds of relationships. For example, A and/or B can indicate that A exists alone, A and B exist simultaneously, and B exists alone. In addition, the character "/" in this application generally indicates that the contextual associated objects belong to an "and/or" relationship.

In this application, the terms "connection", "combination", "coupling" and "installation" may be direct connection, combination, coupling or installation, and may also be indirect connection, combination, coupling or installation. Among them, for example, direct connection means that two members or assemblies are connected together without intermediaries, and indirect connection means that two members or assemblies are respectively connected with at least one intermediate members and the two members or assemblies are connected by the at least one intermediate members. In addition, "connection" and "coupling" are not limited to physical or mechanical connections or couplings, and may include electrical connections or couplings.

In this application, it is to be understood by those skilled in the art that a relative term (such as "about", "approximately", and "substantially") used in conjunction with quantity or condition includes a stated value and has a meaning dictated by the context. For example, the relative term includes at least a degree of error associated with the measurement of a particular value, a tolerance caused by manufacturing, assembly, and use associated with the particular value, and the like. Such relative term should also be considered as disclosing the range defined by the absolute values of the two endpoints. The relative term may refer to plus or minus of a certain percentage (such as 1%, 5%, 10%, or more) of an indicated value. A value that did not use the relative term should also be disclosed as a particular value with a tolerance. In addition, "substantially" when expressing a relative angular position relationship (for example, substantially parallel, substantially perpendicular), may refer to adding or subtracting a certain degree (such as 1 degree, 5 degrees, 10 degrees or more) to the indicated angle.

In this application, those skilled in the art will understand that a function performed by an assembly may be performed by one assembly, multiple assemblies, one member, or multiple members. Likewise, a function performed by a member may be performed by one member, an assembly, or a combination of members.

In this application, the terms "up", "down", "left", "right", "front", and "rear" and other directional words are described based on the orientation or positional relationship shown in the drawings, and should not be understood as limitations to the examples of this application. In addition, in this context, it also needs to be understood that when it is mentioned that an element is connected "above" or "under" another element, it can not only be directly connected "above" or "under" the other element, but can also be indirectly connected "above" or "under" the other element through an intermediate element. It should also be understood that orientation words such as upper side, lower side, left side, right side, front side, and rear side do not only represent perfect orientations, but can also be understood as lateral orientations. For example, lower side may include directly below, bottom left, bottom right, front bottom, and rear bottom.

In this application, the terms "controller", "processor", "central processor", "CPU" and "MCU" are interchangeable. Where a unit "controller", "processor", "central processing", "CPU", or "MCU" is used to perform a specific function, the specific function may be implemented by a single aforementioned unit or a plurality of the aforementioned unit.

In this application, the term "device", "module" or "unit" may be implemented in the form of hardware or software to achieve specific functions.

In this application, the terms "computing", "judging", "controlling", "determining", "recognizing" and the like refer to the operations and processes of a computer system or similar electronic computing device (e.g., controller, processor, etc.).

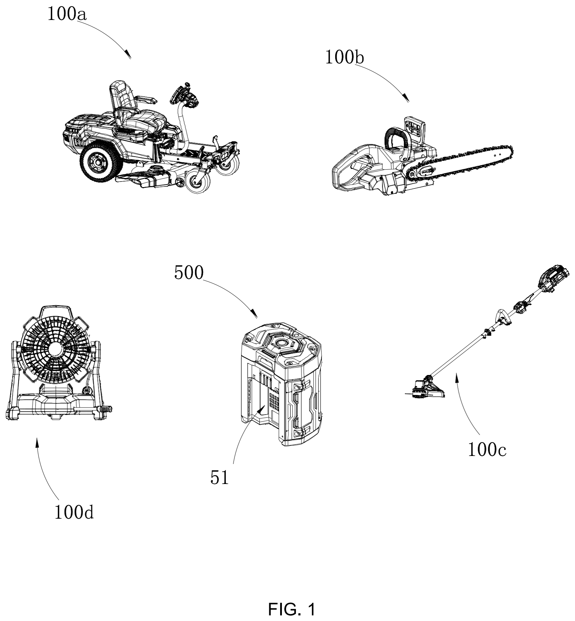

It is to be noted that a battery pack 500 provided in this example of the present application is applicable to power a power tool such as a manned mower 100a, a chainsaw 100b, and a handheld string trimmer 100c or power another electric appliance such as a fan 100d, as shown in FIG. 1. As long as the power tool or the electric appliance adopts the substantial content of the technical solutions disclosed below, the power tool or the electric appliance is within the scope of the present application. The battery pack of the present application includes at least a lithium iron phosphate battery pack, a lithium battery pack, or a full-tab battery pack.

Referring to FIG. 1, the battery pack 500 provided in this example includes a cell assembly and a coupling portion 51. The cell assembly is configured to be connected to a charger through the coupling portion to store electric energy or be connected to the power tool to release electric energy so as to power the power tool. In some examples, the rated voltage U of the battery pack ranges from 24 V to 60 V.

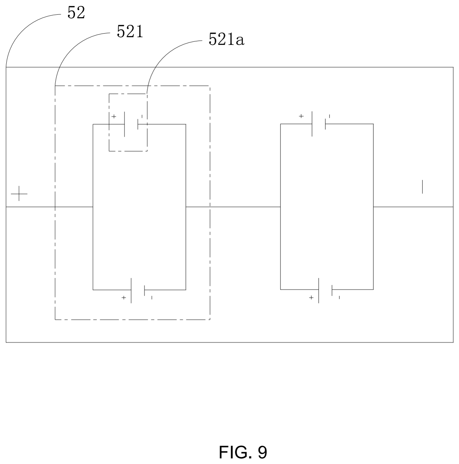

Referring to FIG. 9, the cell assembly 52 includes two cell modules 521 connected in series, and each cell module 521 includes two cells 521a connected in parallel.

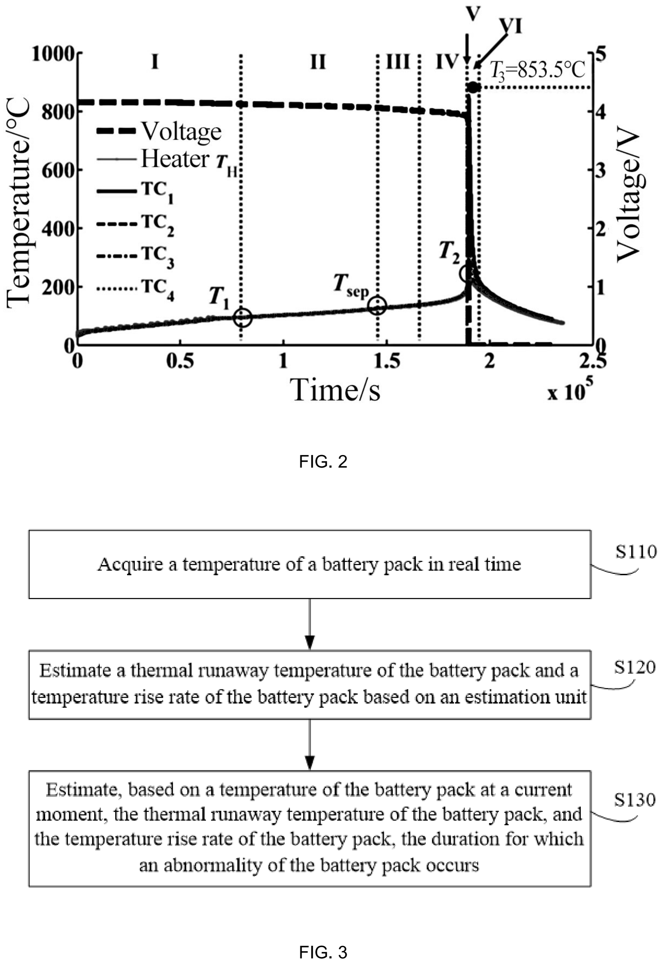

FIG. 2 shows a temperature variation curve during a thermal runaway test of a battery pack according to an example of the present invention. It is to be understood that it is easy to cause the risk of thermal runaway when the cell assembly of the battery pack is at an excessively high temperature. To simulate a thermal runaway process of the battery pack, adiabatic thermometers are placed into the cell assemblies of the four battery packs TC1, TC2, TC3, and TC4, respectively, and the battery packs are heated at a power of 20 W. The heating is stopped after two minutes, and the temperature variations of the battery packs are viewed. When the temperatures of the battery packs no longer rise, the battery packs are continuously heated until thermal runaway occurs in each battery pack. Referring to FIG. 2, the thermal runaway process of each of the battery packs includes 6 stages as the temperature rises. In stage I, when the temperature of the battery pack is greater than 50°C and less than or equal to T1, a solid dielectric interphase (SEI) film on a surface of the negative electrode of a cell starts to decompose. In this case, the negative electrode of the cell is protected by no SEI film, and lithium ions embedded in the negative electrode are in contact with an electrolyte. Thus, a chemical reaction is caused, releasing heat, and a new SEI film is formed. In stage II, when the temperature of the battery pack is greater than T1 and less than or equal to Tsep, a separator substrate starts to melt, the decomposition of the SEI film is accelerated, and the lithium ions embedded in the negative electrode and the electrolyte react and release heat at an increasing rate. In stage III, when the temperature of the battery pack is greater than Tsep, the temperature of the battery pack rises to the melting temperature (about 120°C) of the separator substrate, and the separator substrate melts to absorb heat. In stage IV, the SEI film is completely decomposed, and the lithium ions embedded in the negative electrode fully react with the electrolyte. In this case, a large amount of gas has been generated inside the battery pack, the temperature inside the housing of the cell continuously rises, and the pressure varies sharply. In some examples, if the battery pack includes a safety valve structure, the safety valve structure is already opened in this case. In stage V, when the temperature of the battery pack reaches T2, the positive and negative electrodes of the battery pack collapse, the housing of the cell breaks, and the thermal runaway occurs in the battery pack. In this case, ejected gas is completely combusted, and the temperature reaches the highest point. In stage VI, after the combustion of the combustible gas is finished, the remaining positive and negative electrode materials, the remaining separator, and other structures of the battery pack are continuously combusted, and the temperature of the battery is maintained at about 300°C. This stage is a key stage for causing thermal spread of the battery pack, thereby causing a great loss to a user.

This example provides an abnormality warning method for a battery pack. FIG. 3 is a flowchart of the abnormality warning method for the battery pack according to an example of the present invention. Referring to FIG. 3, the abnormality warning method for the battery pack provided in this example includes the steps described below.

In S110, a temperature of the battery pack is acquired in real time.

The temperature of the battery pack may be a temperature of the cell assembly. In some examples, acquiring the temperature of the battery pack in real time includes acquiring the temperature of the battery pack in real time based on a detection unit. The detection unit may include, but is not limited to, a temperature sensor. The temperature sensor is configured to acquire the temperature of the cell assembly.

In some examples, the battery pack includes at least one cell assembly. The detection unit includes at least one temperature sensor disposed on a surface of the cell assembly. Acquiring the temperature of the battery pack in real time based on the detection unit includes the following: the detection unit acquires sensing data of the temperature sensor in real time and determines the temperature of the surface of the cell assembly according to the data of the sensor.

The battery pack includes the at least one cell assembly, which may be understood as follows: the battery pack includes one cell assembly or multiple cell assemblies. The detection unit includes the at least one temperature sensor, which may be understood as follows: the detection unit includes one temperature sensor or multiple temperature sensors.

In some examples, the battery pack includes multiple cell assemblies, where the multiple cell assemblies include a cell assembly with the fastest temperature rise. The detection unit includes one temperature sensor, and the temperature sensor is disposed on the cell assembly with the fastest temperature rise so that the detection unit can acquire a temperature of the cell assembly with the fastest temperature rise in the battery pack. Thus, the only one temperature sensor is necessarily provided so that the duration for which an abnormality of the battery pack occurs can be accurately estimated.

In some examples, the battery pack includes multiple cell assemblies, where the multiple cell assemblies include a cell assembly with the fastest temperature rise. The detection unit includes multiple temperature sensors. One of the temperature sensors is disposed on the cell assembly with the fastest temperature rise, and the remaining temperature sensors are uniformly disposed on the other cell assemblies. Thus, the detection unit can acquire a more accurate temperature of the battery pack, thereby further improving the accuracy of the estimated duration for which the abnormality of the battery pack occurs.

In S120, a thermal runaway temperature of the battery pack and a temperature rise rate of the battery pack are estimated based on an estimation unit.

The estimation unit is electrically connected to a temperature acquisition unit and a battery management system of the battery pack and can acquire a state parameter, temperature information, and the like of the battery pack.

In some examples, estimating the thermal runaway temperature of the battery pack includes: acquiring at least one of a state of charge (SOC) of the battery pack, a state of health (SOH) of the battery pack, and an internal temperature of a cell; and estimating the thermal runaway temperature based on the at least one of the state of charge of the battery pack, the state of health of the battery pack, and the internal temperature of the cell.

The thermal runaway temperature of the battery pack varies with the SOC of the battery pack and the SOH of the battery pack. In some examples, the higher the SOC of the battery pack, the higher the thermal runaway temperature. Conversely, the lower the SOC of the battery pack, the lower the thermal runaway temperature. In some examples, the higher the SOH of the battery pack, the higher the thermal runaway temperature of the battery pack. Conversely, the lower the SOH of the battery pack, the lower the thermal runaway temperature of the battery pack.

In some examples, acquiring the internal temperature of the cell includes: acquiring a voltage of the battery pack and an internal resistance of the battery pack; and determining the internal temperature of the cell assembly based on the voltage, the internal resistance, and the temperature of the battery pack.

The estimation unit acquires the voltage of the battery pack and the internal resistance of the battery pack through a battery management unit and acquires the temperature of the battery pack through the detection unit. In some examples, the estimation unit performs simulation based on data such as the voltage, internal resistance, and temperature of the battery pack to estimate the internal temperature of the cell assembly.

In S130, the duration for which the abnormality of the battery pack occurs is estimated based on the temperature of the battery pack at a current moment, the thermal runaway temperature of the battery pack, and the temperature rise rate of the battery pack.

The duration for which the abnormality of the battery pack occurs may be understood as the duration after which the thermal runaway occurs in the battery pack. The duration for which the abnormality of the battery pack occurs is related to the temperature of the battery pack at the current moment, the thermal runaway temperature of the battery pack, and the temperature rise rate of the battery pack. The smaller the difference between the thermal runaway temperature of the battery pack and the temperature of the battery pack at the current moment and the higher the temperature rise rate, the shorter the duration for which the abnormality of the battery pack occurs. Conversely, the larger the difference between the thermal runaway temperature of the battery pack and the temperature of the battery pack at the current moment and the lower the temperature rise rate, the longer the duration for which the abnormality of the battery pack occurs.

In some examples, estimating, based on the temperature of the battery pack at the current moment, the thermal runaway temperature of the battery pack, and the temperature rise rate of the battery pack, the duration for which the abnormality of the battery pack occurs includes estimating, according to a first formula based on the temperature of the battery pack at the current moment, the thermal runaway temperature of the battery pack, and the temperature rise rate of the battery pack, the duration for which the abnormality of the battery pack occurs.

The first formula includes the following:

$$\text{t}_{remaining} = \frac{T_{fire} - T_{now}}{Rat\ of\ T_{cell}}\ ;\ \text{where t}_{remaining}\ \text{denotes}$$

the duration for which the abnormality of the battery pack occurs, $T_{fire}$ denotes the thermal runaway temperature, $T_{now}$ denotes the temperature at the current moment, and $Rat$ of $T_{cell}$ denotes the temperature rise rate.

In this example, the temperature of the battery pack is acquired in real time, and the thermal runaway temperature of the battery pack and the temperature rise rate of the battery pack are estimated based on the estimation unit so that the duration for which the abnormality of the battery pack occurs is estimated based on the temperature of the battery pack at the current moment, the thermal runaway temperature of the battery pack, and the temperature rise rate of the battery pack. Thus, the thermal runaway of the battery pack can be warned so that the user knows the occurrence time of the thermal runaway of the battery pack in time, thereby preventing the loss caused by the thermal runaway.

In some examples, the abnormality warning method for the battery pack further includes: outputting a warning signal to notify the user when the duration for which the abnormality of the battery pack occurs is less than or equal to a duration threshold.

The duration threshold may be set according to an actual use scenario of the battery pack and a habit of the user. The greater the duration threshold, the earlier the user is notified. Thus, it is more possible for the user to have enough time to take a corresponding action so as to avoid the thermal runaway of the battery pack. In some examples, the duration threshold is 1 min. In some examples, the duration threshold is 5 min.

The warning signal may include, but is not limited to, a sound warning, a text warning, and/or a light warning. In some examples, when the duration for which the abnormality of the battery pack occurs is less than or equal to the duration threshold, the warning signal is outputted to the body of the power tool or a user terminal to notify the user.

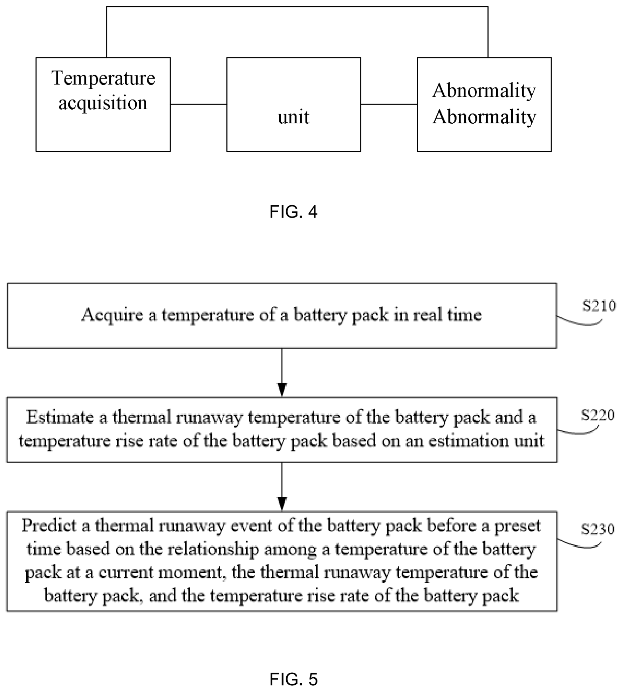

Based on the same concept, an example of the present invention provides a charging system. The charging system can estimate the duration for which the abnormality of the battery pack occurs in a charging process. FIG. 4 is a block diagram of the charging system according to the example of the present invention. Referring to FIG. 4, the charging system provided in this example includes: a battery pack, a charger for charging the battery pack, a temperature acquisition unit, an estimation unit, and an abnormality warning unit. The battery pack includes a cell assembly. The cell assembly is configured to be connected to the charger to store electric energy or be connected to a power tool to release electric energy. The temperature acquisition unit is configured to acquire a temperature of the battery pack in real time. The estimation unit is configured to estimate a thermal runaway temperature of the battery pack and a temperature rise rate of the battery pack. The abnormality warning unit is configured to estimate, based on a current temperature, thermal runaway temperature, and temperature rise rate of the battery pack, the duration for which the abnormality of the battery pack occurs.

In this example, the temperature acquisition unit acquires the temperature of the battery pack in real time, and the thermal runaway temperature of the battery pack and the temperature rise rate of the battery pack are estimated based on the estimation unit so that the abnormality warning unit can estimate, based on the temperature of the battery pack at a current moment, the thermal runaway temperature of the battery pack, and the temperature rise rate of the battery pack, the duration for which the abnormality of the battery pack occurs. Thus, the thermal runaway of the battery pack can be warned so that the user knows the occurrence time of the thermal runaway of the battery pack in time, thereby preventing the loss caused by the thermal runaway.

In some examples, the estimation unit is specifically configured to acquire a voltage of the battery pack and an internal resistance of the battery pack and determine an internal temperature of a cell based on the voltage, the internal resistance, and the temperature of the battery pack.

In some examples, the estimation unit is specifically configured to acquire the voltage of the battery pack and the internal resistance of the battery pack and determine an internal temperature of the cell assembly based on the voltage, the internal resistance, and the temperature of the battery pack.

In some examples, the abnormality warning unit is specifically configured to estimate, based on the temperature of the battery pack at the current moment, the thermal runaway temperature of the battery pack, and the temperature rise rate of the battery pack according to the first formula, the duration for which the abnormality of the battery pack occurs.

The first formula includes the following:

$$t_{remaining} = \frac{T_{fire} - T_{now}}{Rat\ of\ T_{cell}};$$

where $t_{remaining}$ denotes the duration for which the abnormality of the battery pack occurs, $T_{fire}$ denotes the thermal runaway temperature, $T_{now}$ denotes the temperature at the current moment, and $Rat\ of\ T_{cell}$ denotes the temperature rise rate.

Based on the same concept, this example provides an abnormality warning method for a battery pack. FIG. 5 is another flowchart of the abnormality warning method for the battery pack according to an example of the present invention. Referring to FIG. 5, the abnormality warning method for the battery pack provided in this example includes the steps described below.

In S210, the temperature of the battery pack is acquired in real time.

In S220, the thermal runaway temperature of the battery pack and the temperature rise rate of the battery pack are estimated based on the estimation unit.

In S230, a thermal runaway event of the battery pack is predicted before a preset time based on the relationship among the temperature of the battery pack at the current moment, the thermal runaway temperature of the battery pack, and the temperature rise rate of the battery pack.

The preset time may be set according to the actual use scenario of the battery pack and the habit of the user. The longer the preset time, the longer the time for the action to prevent the thermal runaway event of the battery pack. In some examples, the preset time is 1 min. In some examples, the preset time is 5 min.

In this example, the temperature of the battery pack is acquired in real time, and the thermal runaway temperature of the battery pack and the temperature rise rate of the battery pack are estimated based on the estimation unit so that the thermal runaway event of the battery pack is predicted before the preset time based on the temperature of the battery pack at the current moment, the thermal runaway temperature of the battery pack, and the temperature rise rate of the battery pack. Thus, the thermal runaway of the battery pack can be warned in advance so that the user knows the occurrence time of the thermal runaway of the battery pack in time, thereby preventing the loss caused by the thermal runaway.

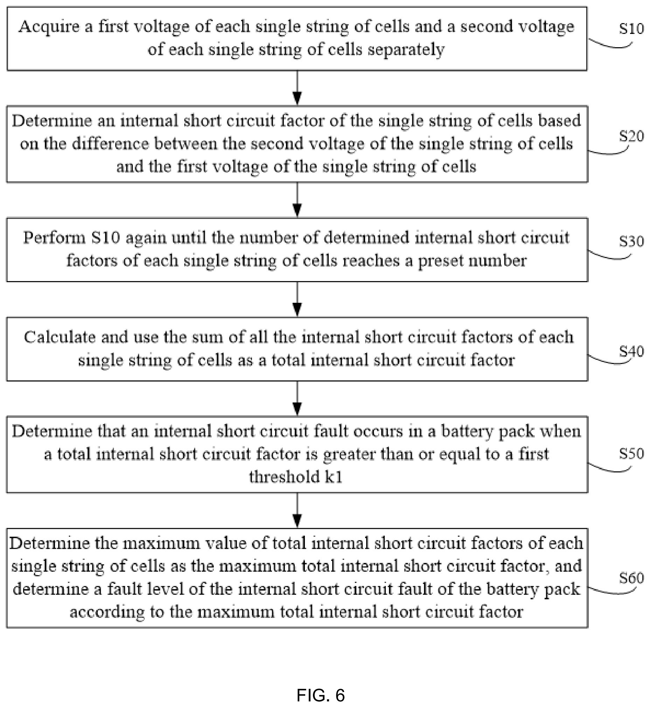

Since an internal short circuit of the battery pack is also an important cause of the thermal runaway of the battery pack, this example further provides an internal short circuit identification method for the battery pack. FIG. 6 is a flowchart of the internal short circuit identification method for the battery pack according to an example of the present invention. Referring to FIG. 6, the internal short circuit identification method for the battery pack includes the steps described below.

In S10, a first voltage of each cell module and a second voltage of each cell module are acquired separately.

The battery pack includes at least one cell module, and each cell module includes at least P cells connected in parallel, where P ≥ 1.

The first voltage and the second voltage are voltages of the cell module at different moments, respectively. In some examples, the first voltage is a voltage of the cell module at a first moment, and the second voltage is a voltage of the cell module at a second moment. The time interval between the first moment and the second moment is a preset time interval. In some examples, the preset time interval is 6 h. In some examples, within the time interval from the acquisition of the first voltage to the acquisition of the second voltage, that is, the preset time interval, the battery pack rests and is allowed to sleep.

In some examples, the moment at which the first voltage is acquired is after balance of the battery pack ends and the battery pack rests for a preset time. In some examples, the preset time is 30 min.

In some examples, after the acquisition of the first voltage but before the acquisition of the second voltage, if the battery pack is used again, for example, the battery pack is discharged or charged, the acquisition of the second voltage is stopped, and the first voltage of each cell module and the second voltage of each cell module are acquired again after the balance of the battery pack ends and the battery pack rests for the preset time.

In S20, an internal short circuit factor of the cell module is determined based on the difference between the second voltage of the cell module and the first voltage of the cell module.

The internal short circuit factor can represent the severity of the internal short circuit. It is to be understood that a self-discharging process beyond a normal range is inevitably caused when the internal short circuit occurs in the battery pack. The internal short circuit factor of the cell module is determined based on the difference between the second voltage of the cell module and the first voltage of the cell module such that it is determined whether the battery pack undergoes an abnormal self-discharging process. In some examples, the larger the difference between the second voltage of the cell module and the first voltage of the cell module, the larger the internal short circuit factor, and the smaller the difference between the second voltage of the cell module and the first voltage of the cell module, the smaller the internal short circuit factor.

In some examples, S20 includes the following: the internal short circuit factor of the cell module is determined according to a second formula based on the difference between the second voltage of the cell module and the first voltage of the cell module.

The second formula is as follows:

$$ \mathrm{k}_{\mathrm{isc}} = \frac{dV_{max} - dV_x}{dV_{threshold}}; $$

where $k_{isc}$ denotes the internal short circuit factor, $dV_{max}$ denotes a reference voltage, $dV_x$ denotes the difference between the second voltage and the first voltage, and $dV_{threshold}$ denotes a voltage threshold.

In an optional example, the reference voltage is the minimum value of the difference between the second voltage of each cell module and the first voltage of each cell module acquired by the battery pack for the first time.

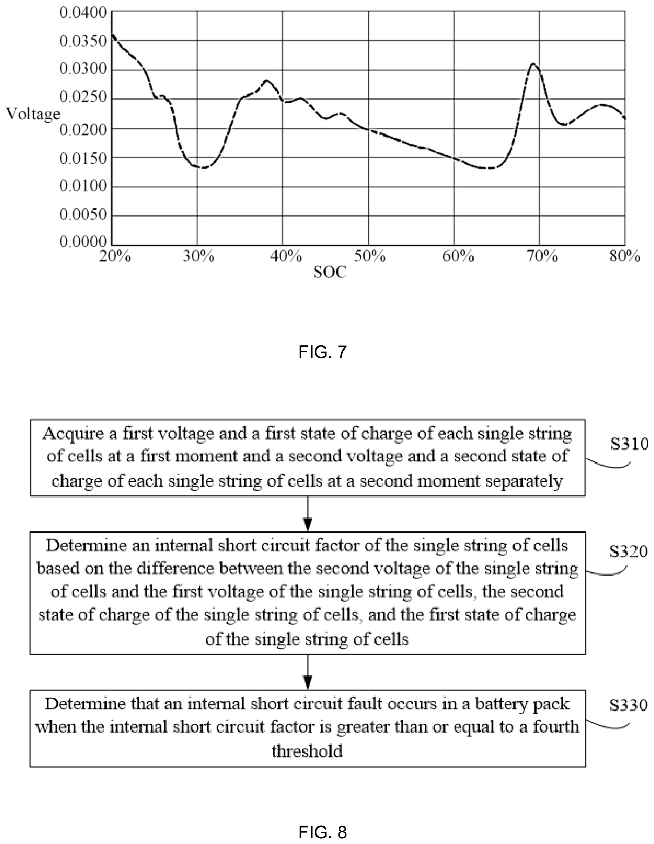

FIG. 7 shows a preset curve according to an example of the present invention. In some examples, referring to FIG. 7, the voltage threshold is determined according to a variation in the state of charge of the battery pack and the preset curve. In an example, if the SOC of the battery pack is 60% at the first moment, the corresponding voltage threshold is 0.015 V in this case, and if the SOC of the battery pack is 50% at the second moment, the corresponding voltage threshold is 0.02 V in this case. Then, the voltage threshold is 0.005 V in this case.

In S30, S10 is performed again until the number of determined internal short circuit factors of each cell module reaches a preset number.

The preset number is greater than or equal to 1. The preset number may be determined according to the number of cells connected in parallel in each cell module. The greater the preset number, the smaller the influence of the parallel connection on the voltage difference of the internal short circuit. In some examples, the preset number is 2. In some examples, the preset number is P+1.

Specifically, if the preset number is 3, the first voltage of each cell module at the first moment and the second voltage of each cell module at the second moment are acquired separately after the balance of the battery pack ends and the battery pack rests for the preset time. The battery pack is not in use and is allowed to sleep at the time interval from the first moment to the second moment. Then, the internal short circuit factor of the cell module is determined based on the difference between the second voltage of the cell module and the first voltage of the cell module. So far, the number of determined internal short circuit factors of the cell module is 1. After the balance of the battery pack ends and the battery pack rests for the preset time again, the first voltage of each cell module at the first moment and the second voltage of each cell module at the second moment are acquired separately, and the internal short circuit factor of the cell module is determined based on the difference between the second voltage of the cell module and the first voltage of the cell module. So far, the number of determined internal short circuit factors of the cell module is 2. Then, after the balance of the battery pack ends and the battery pack rests for the preset time again, the first voltage of each cell module at the first moment and the second voltage of each cell module at the second moment are acquired separately, and the internal short circuit factor of the cell module is determined based on the difference between the second voltage of the cell module and the first voltage of the cell module. So far, the number of determined internal short circuit factors of the cell module is 3, which has reached the preset number. Therefore, the acquisition of the first voltage and second voltage of each cell module is stopped.

In S40, the sum of all the internal short circuit factors of each cell module is calculated and used as a total internal short circuit factor.

In S50, it is determined that an internal short circuit fault occurs in the battery pack when a total internal short circuit factor is greater than or equal to a first threshold k1.

The first threshold k1 may be determined according to a characteristic of the battery pack. When an internal short circuit fault occurs in the cell module, the total internal short circuit factor of the cell module is greater than or equal to the first threshold k1. Specifically, when the total internal short circuit factor of at least one cell module in the battery pack is greater than or equal to the first threshold k1, it indicates that the internal short circuit fault occurs in the cell of the battery, and therefore, it is determined that the internal short circuit fault occurs in the battery pack.

In S60, the maximum value of total internal short circuit factors of each cell module is determined as the maximum total internal short circuit factor $k_{max}$, and a fault level of the internal short circuit fault of the battery pack is determined according to the maximum total internal short circuit factor $k_{max}$.

The fault level of the internal short circuit fault may reflect the severity of the internal short circuit of the battery pack. In some examples, the larger the maximum total internal short circuit factor $k_{max}$, the higher the fault level of the internal short circuit fault of the battery pack.

In some examples, S60 includes the steps described below.

In S61, when $k1 < k_{max} \leq k2$, it is determined that a first-level internal short circuit fault occurs in the battery pack.

In S62, when $k2 < k_{max} \leq k3$, it is determined that a second-level internal short circuit fault occurs in the battery pack.

In S63, when $k_{max} > k3$, it is determined that a three-level short circuit fault occurs in the battery pack.

In the preceding description, $k1 < k2 < k3$.

In some examples, after it is determined that the first-level internal short circuit fault occurs in the battery pack, the method further includes: recording this first-level internal short circuit fault and eliminating or reducing a voltage difference of the battery pack when the balance is performed on the battery pack next time.

In some examples, after it is determined that the second-level internal short circuit fault occurs in the battery pack, the method further includes: controlling a communication module of the battery pack to send first fault information.

The first fault information may include, but is not limited to, an outputted prompt signal such as a sound warning, a text warning, and/or a light warning to the power tool or the user terminal, so as to remind the user to pay attention to the safety risk and repair and check the battery pack in time.

In some examples, after it is determined that the three-level short circuit fault occurs in the battery pack, the method further includes: prohibiting the battery pack from being charged and discharged and controlling the communication module of the battery pack to send second fault information.

The battery pack is prohibited from being charged and discharged, that is, the battery pack is locked, and the use of the battery pack is stopped. The second fault information includes, but is not limited to, an outputted prompt signal such as a sound warning, a text warning, and/or a light warning to the power tool or the user terminal, so as to remind the user to pay attention to the safety risk and repair and check the battery pack in time.

In some examples, the first fault information is the same as the second fault information, and in some examples, the first fault information is different from the second fault information, which is not specifically limited in this example.

In this example, the first voltage of each cell module at the first moment and the second voltage of each cell module at the second moment are acquired separately, and the internal short circuit factor of the cell module is determined based on the difference between the second voltage of the cell module and the first voltage of the cell module. After the number of determined internal short circuit factors of each cell module reaches the preset number, the sum of all the internal short circuit factors of each cell module is calculated and used as the total internal short circuit factor. Thus, when the total internal short circuit factor is greater than or equal to the first threshold k1, it is determined that the internal short circuit fault occurs in the battery pack. Thus, the internal short circuit fault of the battery pack can be found in time and the fault information is outputted so that the internal short circuit fault can be prevented from developing into the thermal runaway, thereby helping improve the use safety of the battery pack and enhance the value and competitiveness of the product.

Based on the same inventive concept, this example further provides a battery pack for powering a power tool. The battery pack includes a cell assembly and a power management unit. The cell assembly includes at least one cell module, and each cell module includes at least P cells connected in parallel. The power management unit is electrically connected to the cell assembly to control the cell assembly to be charged or discharged. The power management unit is configured to calculate an internal short circuit factor of each cell module at least P times based on variations in voltages of each cell module within a preset duration separately, calculate and use the sum of the at least P internal short circuit factors of each cell module as the total internal short circuit factor, and determine that an internal short circuit fault occurs in the battery pack when a total internal short circuit factor is greater than or equal to a first threshold.

In the preceding description, P ≥ 1.

The battery pack for powering the power tool provided in this example includes the cell assembly and the power management unit, and the power management unit is configured to be capable of performing the internal short circuit identification method for the battery pack provided in the preceding example. Therefore, the battery pack can achieve the beneficial effects of the internal short circuit identification method for the battery pack. For the similarities, reference may be made to the preceding description.

Based on the same inventive concept, this example further provides an internal short circuit identification method for a battery pack. FIG. 8 is a flowchart of the internal short circuit identification method for the battery pack according to an example of the present invention. Referring to FIG. 8, the internal short circuit identification method for the battery pack includes the steps described below.

In S310, a first voltage and a first state of charge of each cell module at a first moment and a second voltage and a second state of charge of each cell module at a second moment are acquired separately.

In some examples, the time interval between the first moment and the second moment is 6 h.

In some examples, the moment at which the first voltage is acquired is after balance of the battery pack ends and the battery pack rests for a preset time. In some examples, the preset time is 30 min.

In some examples, after the acquisition of the first voltage and the first state of charge but before the acquisition of the second voltage and the second state of charge, if the battery pack is used again, for example, the battery pack is discharged or charged, the acquisition of the second voltage and the second state of charge is stopped, and the first voltage, second voltage, first state of charge, and second state of charge of each cell module are acquired again after the balance of the battery pack ends and the battery pack rests for the preset time.

In S320, an internal short circuit factor of the cell module is determined based on the difference between the second voltage of the cell module and the first voltage of the cell module, the second state of charge of the cell module, and the first state of charge of the cell module.

In some examples, S320 includes: determining a voltage threshold based on the second state of charge of the cell module, the first state of charge of the cell module, and a preset curve; and determining the internal short circuit factor of the cell module based on the difference between the second voltage of the cell module and the first voltage of the cell module and the voltage threshold and based on the second formula.

The second formula is as follows:

$$k_{isc} = \frac{dV_{max} - dV_x}{dV_{threshold}};$$

where $k_{isc}$ denotes the internal short circuit factor, $dV_{max}$ denotes a reference voltage, $dV_x$ denotes the difference between the second voltage and the first voltage, and $dV_{threshold}$ denotes the voltage threshold.

In some examples, the reference voltage is the minimum value of the difference between the second voltage of each cell module and the first voltage of each cell module acquired by the battery pack for the first time.

In S330, it is determined that an internal short circuit fault occurs in the battery pack when the internal short circuit factor is greater than or equal to a fourth threshold.

The fourth threshold may be determined according to a characteristic of the battery pack. When an internal short circuit fault occurs in the cell module, the internal short circuit factor of the cell module is greater than or equal to the fourth threshold. Specifically, when the internal short circuit factor of at least one cell module in the battery pack is greater than or equal to the fourth threshold, it indicates that the internal short circuit fault occurs in the cell of the battery, and therefore, it is determined that the internal short circuit fault occurs in the battery pack.

In some examples, the internal short circuit identification method for the battery pack further includes the step described below.

When the internal short circuit factor is greater than or equal to a fifth threshold, it is determined that a second-level internal short circuit fault occurs in the battery pack.

The fifth threshold is greater than the fourth threshold.

In some examples, when the second-level internal short circuit fault occurs in the battery pack, a communication module of the battery pack is controlled to send third fault information.

The third fault information may include, but is not limited to, an outputted prompt signal such as a sound warning, a text warning, and/or a light warning to the power tool or the user terminal, so as to remind the user to pay attention to the safety risk and repair and check the battery pack in time. In some examples, the third fault information is the same as the first fault information. In some examples, the third fault information is different from the first fault information.

In some examples, the internal short circuit identification method for the battery pack further includes the following: when the internal short circuit factor is greater than or equal to a sixth threshold, it is determined that a third-level internal short circuit fault occurs in the battery pack.

The sixth threshold is greater than the fifth threshold.

In some examples, when the three-level internal short circuit fault occurs in the battery pack, the battery pack is prohibited from being charged and discharged and the communication module of the battery pack is controlled to send fourth fault information.

The fourth fault information includes, but is not limited to, an outputted prompt signal such as a sound warning, a text warning, and/or a light warning to the power tool or the user terminal, so as to remind the user to pay attention to the safety risk and repair and check the battery pack in time. In some examples, the fourth fault information is the same as the second fault information, and in some examples, the fourth fault information is different from the second fault information, which is not specifically limited in this example.

Based on the same inventive concept, this example further provides a battery pack for powering a power tool. The battery pack includes a cell assembly and a power management unit. The cell assembly includes at least one cell module, and each cell module includes at least two cells connected in parallel. The power management unit is electrically connected to the cell assembly to control the cell assembly to be charged or discharged. The power management unit is configured to calculate an internal short circuit factor of the cell module based on a variation in a state of charge of the cell module and a variation in a voltage of the cell module within a preset period and determine that an internal short circuit fault occurs in the battery pack when the internal short circuit factor is greater than or equal to a fourth threshold.

In the preceding description, $P \geq 1$.

The battery pack for powering the power tool provided in this example includes the cell assembly and the power management unit, and the power management unit is configured to be capable of performing the internal short circuit identification method for the battery pack provided in the preceding example. Therefore, the battery pack can achieve the beneficial effects of the internal short circuit identification method for the battery pack. For the similarities, reference may be made to the preceding description.

The basic principles, main features, and advantages of this application are shown and described above. It is to be understood by those skilled in the art that the aforementioned examples do not limit the present application in any form, and all technical solutions obtained through equivalent substitutions or equivalent transformations fall within the scope of the present application.

**Claims**

1.  An internal short circuit identification method for a battery pack (500), wherein the battery pack comprises at least one cell module (521), and each cell module of the at least one cell module comprises at least P cells (521a) connected in parallel, wherein $P \geq 1$;
    wherein the method comprises:

    acquiring voltages of the cell module at a first moment and voltages of the cell module at a second moment;
    calculating an internal short circuit factor of the cell module based on variations between the voltages at the second moment and the voltages at the first moment;
    calculating the internal short circuit factor at least two times in a cumulative manner and calculating a sum of all internal short circuit factors; and
    determining that an internal short circuit fault occurs in the battery pack when the calculated sum of all the internal short circuit factors exceeds a first threshold k1.

2.  The internal short circuit identification method according to claim 1, wherein a first voltage of each cell module and a second voltage of each cell module are acquired separately after balance of the battery pack ends and the battery pack rests for a preset time.

3.  The internal short circuit identification method according to claim 1, wherein a maximum value of total internal short circuit factors of each cell module is determined as a maximum total internal short circuit factor $k_{max}$, and a fault level of the internal short circuit fault of the battery pack is determined according to the maximum total internal short circuit factor $k_{max}$.

4.  The internal short circuit identification method according to claim 3, wherein when $k1 < k_{max} \leq k2$, it is determined that a first-level internal short circuit fault occurs in the battery pack, wherein k2 is a second threshold.

5.  The internal short circuit identification method according to claim 4, wherein when $k2 < k_{max} \leq k3$, it is determined that a second-level internal short circuit fault occurs in the battery pack, wherein k3 is a third threshold.

6.  The internal short circuit identification method according to claim 5, wherein after it is determined that the second-level internal short circuit fault occurs in the battery pack, a communication module of the battery pack is controlled to send first fault information.

7. The internal short circuit identification method according to claim 5, wherein when $k_{max} > k3$, it is determined that a three-level short circuit fault occurs in the battery pack.

8. The internal short circuit identification method according to claim 7, wherein after it is determined that the three-level short circuit fault occurs in the battery pack, the battery pack is prohibited from being charged and discharged and a communication module of the battery pack is controlled to send second fault information.

9. The internal short circuit identification method according to claim 1, wherein the internal short circuit factor of the cell module is determined according to a formula based on a difference between a second voltage of the cell module and a first voltage of the cell module, wherein the formula is as follows:

$$k_{isc} = \frac{dV_{max} - dV_x}{dV_{threshold}};$$

wherein $k_{isc}$ denotes the internal short circuit factor, $dV_{max}$ denotes a reference voltage, $dV_x$ denotes the difference between the second voltage and the first voltage, and $dV_{threshold}$ denotes a voltage threshold.

10. The internal short circuit identification method according to claim 9, wherein the voltage threshold is determined according to a variation in a state of charge (SOC) of the battery pack and a preset curve.

11. The internal short circuit identification method according to claim 9, wherein the reference voltage is a minimum value of a difference between a second voltage of each cell module and a first voltage of each cell module acquired by the battery pack for a first time.

12. A battery pack (500) applicable to power a power tool, comprising:

a cell assembly (52) comprising at least one cell module (521), wherein each cell module of the at least one cell module comprises at least P cells (521a) connected in parallel, wherein $P \geq 1$; and a power management unit electrically connected to the cell assembly to control the cell assembly to be charged or discharged, calculating an internal short circuit factor of the cell module at least P times based on variations in voltages of the cell module within a preset duration separately, and determining that an internal short circuit fault occurs in the battery pack when a sum of the calculated at least P internal short circuit factors exceeds a first threshold.

100a

100b

500

51

100c

100d

FIG. 1

FIG. 2

FIG. 3

| Temperature acquisition | unit | Abnormality Abnormality |
|---|---|---|

FIG. 4

| Acquire a temperature of a battery pack in real time | S210 |
|---|---|
| Estimate a thermal runaway temperature of the battery pack and a temperature rise rate of the battery pack based on an estimation unit | S220 |
| Predict a thermal runaway event of the battery pack before a preset time based on the relationship among a temperature of the battery pack at a current moment, the thermal runaway temperature of the battery pack, and the temperature rise rate of the battery pack | S230 |

FIG. 5

Acquire a first voltage of each single string of cells and a second voltage of each single string of cells separately — S10

Determine an internal short circuit factor of the single string of cells based on the difference between the second voltage of the single string of cells and the first voltage of the single string of cells — S20

Perform S10 again until the number of determined internal short circuit factors of each single string of cells reaches a preset number — S30

Calculate and use the sum of all the internal short circuit factors of each single string of cells as a total internal short circuit factor — S40

Determine that an internal short circuit fault occurs in a battery pack when a total internal short circuit factor is greater than or equal to a first threshold k1 — S50

Determine the maximum value of total internal short circuit factors of each single string of cells as the maximum total internal short circuit factor, and determine a fault level of the internal short circuit fault of the battery pack according to the maximum total internal short circuit factor — S60

FIG. 6

FIG. 7

Acquire a first voltage and a first state of charge of each single string of cells at a first moment and a second voltage and a second state of charge of each single string of cells at a second moment separately — S310

Determine an internal short circuit factor of the single string of cells based on the difference between the second voltage of the single string of cells and the first voltage of the single string of cells, the second state of charge of the single string of cells, and the first state of charge of the single string of cells — S320

Determine that an internal short circuit fault occurs in a battery pack when the internal short circuit factor is greater than or equal to a fourth threshold — S330

FIG. 8

FIG. 9

| | Europäisches Patentamt European Patent Office Office européen des brevets | **EUROPEAN SEARCH REPORT** | Application Number EP 25 21 0929 |

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | KR 2024 0014216 A (KOREA INST ENERGY RES [KR]) 1 February 2024 (2024-02-01) * abstract * * figures 1-3 * * paragraphs [0003] - [0094] * * paragraphs [0113] - [0118] * * claims 1,9 *<br>----- | 1-12 | INV. G01R31/52 G01R31/396 G01R31/56 |
| A | US 2020/072912 A1 (CHUN CHANGYOON [KR] ET AL) 5 March 2020 (2020-03-05) * abstract * * figures 1-6 * * paragraphs [0005] - [0026], [0045] - [0117] *<br>----- | 1-12 | |
| A | US 2022/016996 A1 (YANG RUI [CN] ET AL) 20 January 2022 (2022-01-20) * abstract * * figures 1-12 * * paragraphs [0002], [0005] - [0064], [0084] - [0276] *<br>----- | 1-12 | |
| | | | TECHNICAL FIELDS SEARCHED (IPC) |
| | | | G01R H01M |

The present search report has been drawn up for all claims

| Place of search | Date of completion of the search | Examiner |
|---|---|---|
| The Hague | 26 March 2026 | Mouanda, Thierry |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 21 0929

This annex lists the patent family members relating to the patent documents cited in the above-mentioned European search report.
The members are as contained in the European Patent Office EDP file on
The European Patent Office is in no way liable for these particulars which are merely given for the purpose of information.

26-03-2026

| Patent document cited in search report | Publication date | Patent family member(s) | | Publication date |
|---|---|---|---|---|
| KR 20240014216 A | 01-02-2024 | NONE | | |
| US 2020072912 A1 | 05-03-2020 | KR | 20200024637 A | 09-03-2020 |
| | | US | 2020072912 A1 | 05-03-2020 |
| US 2022016996 A1 | 20-01-2022 | CN | 111856316 A | 30-10-2020 |
| | | EP | 3943961 A1 | 26-01-2022 |
| | | JP | 2022528879 A | 16-06-2022 |
| | | US | 2022016996 A1 | 20-01-2022 |
| | | WO | 2020199928 A1 | 08-10-2020 |

EPO FORM P0459

For more details about this annex : see Official Journal of the European Patent Office, No. 12/82